(19) **Europäisches Patentamt / European Patent Office / Office européen des brevets**

(11) **EP 2 115 181 B1**

(12) **FASCICULE DE BREVET EUROPEEN**

(45) Date de publication et mention
de la délivrance du brevet:
**17.11.2010 Bulletin 2010/46**

(21) Numéro de dépôt: **08775661.5**

(22) Date de dépôt: **03.03.2008**

(51) Int Cl.:
***C23C 14/00*** *(2006.01)*

(86) Numéro de dépôt international:
**PCT/FR2008/050358**

(87) Numéro de publication internationale:
**WO 2008/122738 (16.10.2008 Gazette 2008/42)**

(54) **PROCEDE D'ASSEMBLAGE D'AU MOINS DEUX PLAQUES ET UTILISATION DU PROCEDE POUR LA REALISATION D'UN ENSEMBLE DE PULVERISATION IONIQUE**

VERFAHREN ZUR MONTAGE VON MINDESTENS ZWEI PLATTEN UND VERWENDUNG DIESES VERFAHRENS ZUR HERSTELLUNG EINER IONENSPUTTERANORDNUNG

METHOD FOR ASSEMBLING AT LEAST TWO PLATES AND USE OF SAID METHOD FOR MAKING AN IONIC SPUTTERING ASSEMBLY

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **05.03.2007 FR 0753648**

(43) Date de publication de la demande:
**11.11.2009 Bulletin 2009/46**

(73) Titulaire: **H.E.F.**
**42160 Andrezieux-Boutheon (FR)**

(72) Inventeurs:
• **MARTIN, Michel**
**F-38780 Septeme (FR)**
• **MAURIN-PERRIER, Philippe**
**F-42680 Saint Marcellin En Forez (FR)**
• **HEAU, Christophe**
**F-42100 Saint-etienne (FR)**
• **BLANDENET, Olivier**
**F-38240 Meylan (FR)**

(74) Mandataire: **Thivillier, Patrick et al**
**Cabinet Laurent & Charras**
**3 Place de l'Hôtel de Ville**
**B.P. 203**
**42005 Saint-Etienne Cedex 1 (FR)**

(56) Documents cités:
**US-A1- 2006 070 876**

**Description**

L'invention concerne le domaine technique de l'assemblage de cible de pulvérisation ionique sur une plaque support.

Plus généralement, l'invention peut être appliquée pour tout type d'assemblage entre deux plaques selon un écartement précis. Cette nécessité de réaliser un assemblage entre deux plaques, selon un écartement précis, est particulièrement important pour les cibles de pulvérisation utilisées dans tous les domaines d'application des couches minces déposées sous vide (micro-électronique, mécanique, automobile, optique, écran plat, film pour l'emballage, ...).

On rappelle, d'une manière parfaitement connue pour un homme du métier, qu'un dépôt physique en phase vapeur se fait dans une chambre à pression réduite, dans laquelle un plasma entre un pôle positif et un pôle négatif, en combinaison avec un gaz (argon par exemple), en utilisant soit un courant continu, soit un courant pulsé, soit un courant haute fréquence.

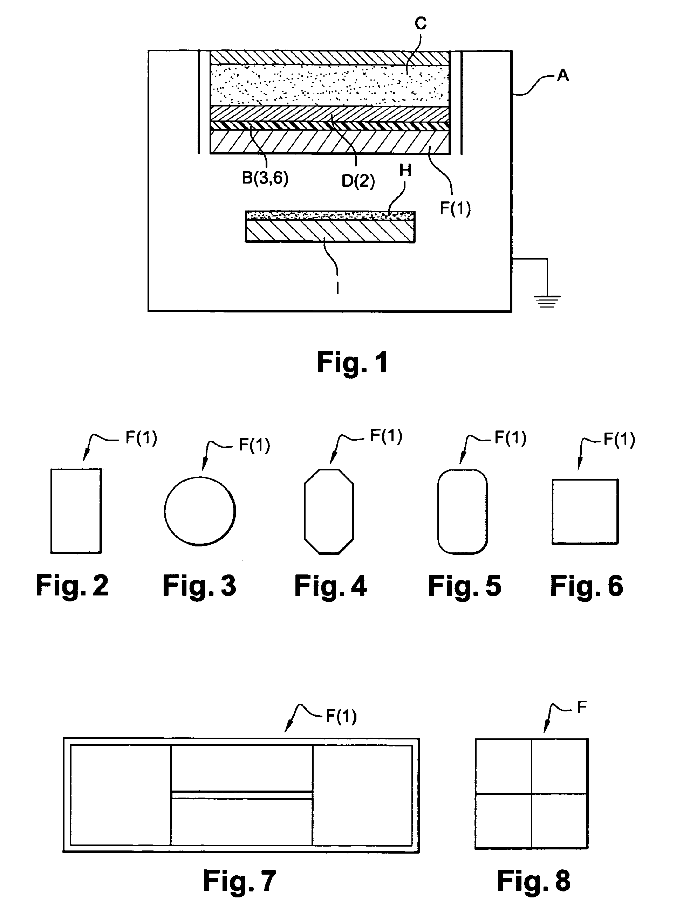

On renvoie à la figure 1 qui montre schématiquement les principaux éléments d'une chambre de dépôt physique en phase vapeur.

Dans cet exemple de pulvérisation ionique, le pôle positif est constitué par les parois de l'enceinte (A), tandis que le pôle négatif est constitué par une cible de pulvérisation (F) qui est le siège de bombardement ionique. Les atomes de la cible (F) se condensent sur un substrat (I) pour former un dépôt en couche mince (H). La cible (F) est fixée sur une plaque support (D) généralement associée à un élément refroidisseur (C).

La cible (F) est fixée à la plaque support (D) par un système de liaison ou joint (B).

Cette liaison entre la cible de pulvérisation et la plaque support doit être effectuée pour répondre à certains impératifs, notamment de tenue en température de conduction thermique, de conduction électrique, de dégazage sous vide, de contamination de la cible, ...

Différentes solutions techniques ont été proposées pour réaliser l'assemblage et la liaison entre la cible de pulvérisation et la plaque support. On peut utiliser, par exemple, une couche continue de brasure formée entre la cible et la plaque support.

Selon l'enseignement du document US 2006/0266643, la liaison est réalisée au moyen d'une couche mince continue de colle, en combinaison avec une grille. Soit selon le document US20060283703 la couche de colle est formée de lignes dont la géométrie n'est pas précisée (largeur, hauteur, longueur), soit des lignes parallèles, soit des lignes formant réseaux, soit des lignes formant des couronnes concentriques.

Ces différentes méthodes permettent d'obtenir des résultats satisfaisants, mais difficiles à mettre en oeuvre. Notamment des difficultés importantes apparaissent pour régler l'épaisseur de la couche de colle, par exemple comme il ressort du document WO 2006/132916. En outre, les colles utilisées doivent répondre à des caractéristiques spécifiques déterminées en général d'un coût important. Des difficultés peuvent également apparaître en fonction de la forme et des dimensions de la cible utilisée.

Comme il ressort du document WO 2006/132916, l'emprisonnement de gaz, dans une couche de colle, peut produire une dégradation de la solidité des joints lors de la mise sous vide par la formation de bulles liées à la diminution de pression extérieure et emprisonnées dans le joint.

L'invention s'est fixée pour but de remédier à ces inconvénients d'une manière simple, sûre, efficace et rationnelle.

Le problème que se propose de résoudre l'invention est de pouvoir réaliser un assemblage de n'importe quelle forme de cible plane (en secteurs ou non, de grandes ou de petites dimensions) sur son support avec pour objectif d'obtenir une très grande régularité de l'épaisseur de la zone de fixation, pour obtenir notamment une conduction thermique régulière et une bonne aptitude à supporter les chocs thermiques.

Pour résoudre un tel problème, il a été conçu et mis au point un procédé d'assemblage d'au moins deux plaques, selon lequel :

-  on dépose, sur l'une des plaques, des plots d'une matière adhésive espacés les uns des autres ;
-  on applique, sur la plaque recevant les plots, une grille d'épaisseur déterminée inférieure à celle des plots ;
-  on exerce une pression perpendiculaire et uniforme sur l'une au moins des plaques, de sorte que les plots s'étalent et viennent en contact avec les faces en regard des deux plaques ;
-  l'espacement des plots est déterminé pour qu'après étalement sous la pression exercée, l'air ne soit pas emprisonné entre lesdits plots.

Comme indiqué, l'invention trouve une application particulièrement avantageuse dans le domaine des couches minces déposées sous vide, de sorte que l'une des plaques constitue la cible de pulvérisation, tandis que l'autre plaque constitue le support de ladite cible.

Pour résoudre le problème posé d'obtenir une épaisseur constante et précise du joint constitué par la couche de matière adhésive, la grille délimite des ouvertures de formes géométriques quelconques de surface inférieure à celle des plots. Le taux d'ouverture de la grille est compris entre 20 et 50 %.

Selon une autre caractéristique, la matière adhésive est une colle. La colle est sélectionnée pour polymériser au contact de l'air humide à température ambiante. La colle est un élastomère silicone de type acétoxy.

L'invention est exposée ci-après plus en détail à l'aide des figures des dessins annexés dans lesquels :

- la figure 1 est une vue à caractère schématique montrant les principaux éléments d'une chambre de dépôt physique en phase vapeur ;
- les figures 2, 3, 4, 5, 6, 7 et 8 montrent différents exemples indicatifs nullement limitatifs de formes de cibles planes, susceptibles d'être utilisées selon les caractéristiques de l'invention ;

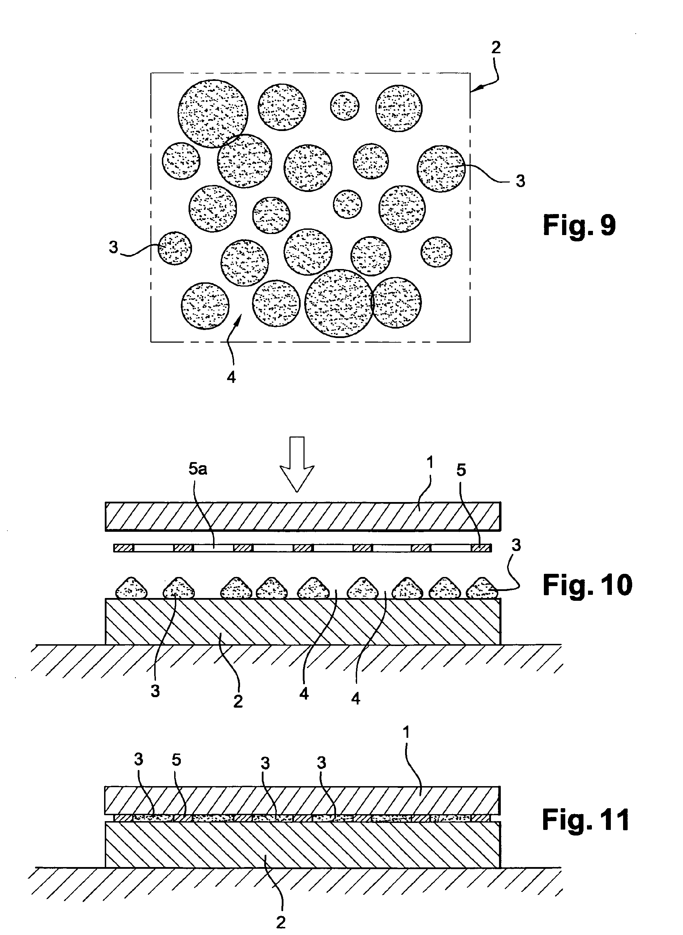

- la figure 9 est un exemple d'une vue partielle et en plan montrant l'une des plaques avec un réseau de plots de colle ;
- la figure 10 est une vue en coupe à caractère schématique avant assemblage de la cible de pulvérisation sur la plaque support selon les caractéristiques de l'invention ;
- la figure 11 est une vue correspondant à la figure 10 après mise en pression des deux plaques correspondant à l'assemblage de la cible sur la plaque support.

La description qui suit s'applique à la fixation de deux plaques (1) et (2) dont l'une (1) constitue une cible de pulvérisation, tandis que l'autre (2) constitue une plaque support.

Cet exemple ne doit pas être considéré comme limitatif.

Selon l'invention, on dispose, sur l'une des faces de la plaque (1) ou de la plaque (2), des plots (3) d'une matière adhésive. Ces plots (3) sont disposés de manière à constituer un réseau avec des espacements (4) entre chaque plot. Sur la face de la plaque (2) avec les plots (3), est appliquée une grille (5) dont l'épaisseur (E) est déterminée et inférieure à la hauteur (h) des plots de (3). Lorsqu'une pression est exercée perpendiculairement et uniformément sur l'une au moins des plaques, les plots de matière adhésive (3) s'étalent et viennent en contact avec les faces en regard (1a) et (2a) des deux plaques (1) et (2).

Selon l'invention et de manière importante, l'espacement des plots (3) est déterminé pour qu'après étalement sous la pression exercée, l'air n'est pas emprisonné entre lesdits plots (3).

Autrement dit, un des points clés de l'invention consiste à régler le volume et l'espacement du réseau des plots (3) de matière adhésive, de telle sorte qu'ils ne percolent pas après écrasement.

Les plots (3) de matière adhésive peuvent avoir une forme sensiblement circulaire ou présenter d'autres formes géométriques (carrée, rectangulaire, ...).

Ce réseau ouvert de plots de matière adhésive (3) assure la fonction de dégazage. A noter que des points de contact entre deux plots adjacents peuvent être acceptables dans la mesure où les zones non recouvertes de matière adhésive ne sont pas fermées par une ligne continue de ladite matière adhésive.

Les caractéristiques dimensionnelles des plots (3) de matière adhésive et leur espacement, en fonction des caractéristiques de la grille (3) utilisée, peuvent être établies comme suit :

En considérant que les plots (3), avant mise en pression des deux plaques (1) et (2) ont une forme correspondant sensiblement à celle d'un cône, de hauteur (h) égale sensiblement à son rayon (R), le volume (Vc) du plot peut être déterminé par la formule suivante :

$$\text{Vc} = 1/3(\pi R^2 h) \approx 1/3(\pi R^3), \text{ d'où } h \approx R \approx \sqrt[3]{\frac{3Vc}{\pi}}$$

Comme indiqué, la hauteur du plot (3) de matière adhésive doit être supérieure à l'épaisseur (E) de la grille (5) pour s'étaler lors de la mise en pression des deux plaques (1) et (2). La hauteur du plot est, environ, au moins 5 fois supérieure à l'épaisseur de la grille.

Après la mise en position des deux plaques (1) et (2), chaque plot de matière adhésive (3), de volume (Vc), s'étale sensiblement sous forme d'un disque de diamètre (D) en fonction de l'épaisseur (E) de la grille (5) et de sa porosité selon la formule :

$$D = 2\sqrt{\frac{Vc}{\pi EP}}$$

Par exemple, une grille de fil de 65μm de diamètre tissé pour donner une grille d'épaisseur totale (E) de 130μm et de taux d'ouverture de 40% aura une porosité (P) voisine de 0,7 (70%).

Si on prend un plot de colle de 10 mm$^3$ ,leur hauteur initiale sera sensiblement de 1,4mm selon l'approximation ci-dessus. Avec une telle grille, le diamètre (D) du disque de colle final sera :

$$D = 2\sqrt{\frac{Vc}{\pi EP}} = 2\sqrt{\frac{10}{\pi x 0,13 x 0,7}} = 11,8 \text{ mm}$$

Dans le cas d'un réseau carré ou en quinconce avec un espacement régulier de plots, il faut que la distance entre ces plots (le pas) soit supérieure au diamètre final des plots de colle, soit, dans l'exemple, supérieure à 11,8 mm. Il faut 2 à 3 mm d'écart entre les plots au final pour éviter les points de contact entre les plots, soit, en l'espèce, Pas=11.8+ (2 ou 3)=14 à 15 mm environ.

D'une manière générale, la grille (5) délimite des ouvertures (5a) de forme géométrique quelconque, de surface inférieure à celle des plots. Le taux d'ouverture de la grille (5) est compris entre 20 et 50 %, par exemple 30 ou 40 %.

Avantageusement, la matière adhésive constitutive des plots (3) est une colle.

Aucune restriction n'est faite sur le type de colle qui peut être employée avec ce procédé. Il s'agit, pour chaque application, de définir les compatibilités et les efficacités de collage aussi bien sur la plaque support que sur la cible. Le choix de la colle tient compte des impératifs de tenue en température, de conduction thermique, de conduction électrique, de dégazage sous vide, de contamination de la cible.

Si nécessaire, on peut opérer un traitement ou un revêtement de surface aussi bien sur la face de la cible que sur la face de la plaque à assembler afin d'améliorer l'adhérence de la colle, afin de limiter la diffusion de la colle, ou d'un de ses composants, dans la cible. Le fait que le réseau de plots (3) de colle ne percole pas, permet, en outre, d'utiliser des colles ou mastic-colles de type acétoxy qui polymérisent à l'air grâce à la présence de l'humidité. D'autres types de colle nécessitant la présence d'un gaz ou produisant l'évacuation d'un résidu de réaction, peuvent être employés avec cette méthode d'assemblage.

Compte tenu des caractéristiques à la base de l'invention, le procédé d'assemblage peut s'appliquer à toute forme de cible, comme il ressort des exemples indicatifs, nullement limitatifs, des figures 2 à 8.

Exemple N° 1

Afin de réaliser de dépôts de couches minces d'électrolytes de type LiPON, on prend une cible de pulvérisation cathodique magnétron haute fréquence de céramique de type Li$_3$PO$_4$ constituée de 4 plaques de 5 mm d'épaisseur et dont deux plaques (secteurs) ont une dimension de 130 x 140 mm et deux plaques ont une dimension de 180 x 65 qui sont assemblées sur une plaque support de cuivre de dimension 450 x 150 x 6 mm, comme montré figure 7, laissant au centre une lumière de 10 x 180 mm et sur le pourtour une bordure de 5 mm de large. L'espacement entre les plaques est ajusté à 0,3 mm.

On dispose sur l'ensemble de la surface de la plaque support une grille de cuivre ayant un taux d'ouverture de 40 % et de porosité 0.7 constituée de fils de cuivre de 65μm (soit épaisseur totale de la grille : environ 130μm). On dépose ensuite un réseau de plots de colle, selon un réseau carré de volume compris entre 10 et 20 mm$^3$ et espacés de 16 à 21 mm dans les deux directions du réseau carré.

On dispose alors les différents secteurs de cibles (figure 7) sur la grille et les plots de colle. On presse l'ensemble entre deux plaques parallèles avec une force de 2000 N appliquée perpendiculairement aux plaques pendant 48 heures à l'air 20°C et 40 % HR.

On obtient une cible de pulvérisation pouvant être pulvérisée sous une puissance de 1,5 kW sous 0.8 Pa d'azote pur. On observe qu'il se forme un réseau de fissures dans les plaques céramiques qui constituent la cible, et perpendiculaires aux plaques de céramique. Ces fissures sont dues à la différence de température entre les deux faces de la céramique lors de la pulvérisation (chaud côté plasma et froid côté refroidisseur). On note que la pression de travail lors de la pulvérisation reste stable aux alentours de 0.8 Pa et que les paramètres électriques de la pulvérisation sont très stables. On obtient des couches minces d'excellente reproductibilité et d'excellente qualité avec cet assemblage. On note que le réseau de fissures reste stable et qu'il n'engendre pas de dégradation supplémentaire de la cible. Tous ces résultats attestent de la qualité de l'assemblage.

Exemple N° 2

On utilise une cible de pulvérisation d'oxyde mixte Indium étain (ITO) de 2 m de longueur sur 1 m de largeur, composée de plaques de 500 x 200 x 5 mm. On dispose d'une plaque support, d'un seul tenant, en acier Inox de 2 x 1 m et d'épaisseur 5 mm. Cette plaque support est abrasée au papier abrasif grade 200 afin d'y créer une rugosité propice à l'adhérence d'une colle. Elle est ensuite dépoussiérée par un jet puissant d'air filtré. La plaque support est disposée à plat à l'horizontal. On dépose sur la plaque un réseau de triangles isocèles de plots de colle chargée à la poudre d'aluminium, le volume de chaque plot étant compris entre 20 et 50 mm$^3$, les plots étant espacés les uns des autres de 20 à 30 mm. On y dépose ensuite une grille en cuivre d'épaisseur totale 0.2 mm, de diamètre de fil 0.1 mm et de taux d'ouverture 30 % et de porosité 0.65. Les plaques d'ITO sont alors déposées sur la grille et les plots de colle avec un écartement entre les plaques d'ITO ne dépassant pas 0.3 mm. L'ensemble est introduit dans un sac dans lequel on fait le vide jusqu'à 1 mbar. Le sac est ensuite scellé de façon étanche. L'ensemble est alors introduit dans une enceinte à pressurisation qui est refermée et portée à 4 bars. Le tout est maintenu 48 h à température ambiante. La cible de pulvérisation est sortie de l'enceinte et ensuite du sac. Elle est montée sur le refroidisseur de la cathode puis l'ensemble est mis sous vide.

Après une mise en puissance progressive au cours de laquelle on observe un dégazage modéré, la cible atteint la puissance nominale de 1.5 watt/cm$^2$. On mesure les performances des couches minces d'ITO réalisées avec cette cible, ainsi que la température atteinte par les substrats. Toutes les performances sont comparables à celles généralement obtenues aussi bien en termes d'uniformité qu'en termes de qualité.

A noter que n'importe quel type de grille (5) peut être utilisé à condition que la colle ou autre matière adhésive puisse passer de part et d'autre de la grille, lors de l'opération d'assemblage correspondant à la mise en pression des deux plaques. Pour les applications où la cible est pulvérisée selon un procédé magnétron, la grille est réalisée dans un matériau non ferromagnétique (cuivre, aluminium, ...). On n'exclut pas d'utiliser des matériaux ferromagnétique dont le but est, par exemple, de faire passer des lignes de champs magnétiques ou lorsqu'un tel matériau ne présente pas un inconvénient.

Les avantages ressortent bien de la description, en particulier on souligne et on rappelle :

- le réseau de plots de colle ou autre matière adhésive, apporte une excellente homogénéité dans l'assemblage et ce quelle que soit la forme de la cible évitant ainsi les caractéristiques directionnelles en opposition à une couche de colle appliquée sous forme de lignes parallèles ;
- la possibilité de défaire plus facilement l'assemblage (cible/support) du fait de la porosité dudit assemblage dont tous les points sont d'un accès relativement aisé par un fluide quelconque permettant d'attaquer ledit assemblage et par conséquent de réutiliser assez facilement les plaques support quand la cible est usée ;
- la possibilité d'utiliser des colles polymériques du type acétoxy (exemple 1) dont la polymérisation est assurée par l'humidité de l'air, de telles colles étant d'un faible coût, d'une tenue jusqu'à au moins 230°C, tout en présentant une bonne élasticité.

**Revendications**

1. Procédé d'assemblage d'au moins deux plaques (1) et (2), **caractérisé en ce que :**

   - on dépose, sur l'une des plaques (2), des plots (3) d'une matière adhésive espacés les uns des autres ;
   - on applique sur la plaque (2) recevant les plots (3) une grille (5) d'épaisseur déterminée inférieure à celle des plots (3) ;
   - on exerce une pression perpendiculaire et uniforme sur l'une au moins des plaques, de sorte que les plots (3) s'étalent et viennent en contact avec les faces en regard de deux plaques (1) et (2) ;
   - l'espacement (4) des plots est déterminé pour qu'après étalement sous la pression exercée, l'air ne soit pas emprisonné entre lesdits plots.

2. Procédé selon la revendication 1, **caractérisé en ce que** la grille (5) délimite des ouvertures de formes géométriques quelconques de surface inférieure à celle des plots.

3. Procédé selon la revendication 1, **caractérisé en ce que** le taux d'ouverture de la grille est compris entre 20 et 50 %.

4. Procédé selon la revendication 1, **caractérisé en ce que** la matière adhésive est une colle.

5. Procédé selon la revendication 4, **caractérisé en ce que** la colle est sélectionnée pour polymériser au contact de l'air humide à température ambiante.

6. Procédé selon la revendication 1, **caractérisé en ce que** la colle est un élastomère silicone de type acétoxy.

7. Utilisation du procédé d'assemblage selon l'une quelconque des revendications 1 à 6 pour la réalisation d'une cible de pulvérisation ionique, l'une des plaques (1) constituant la cible en tant que telle, tandis que l'autre plaque constitue le support de ladite cible.

8. Ensemble de pulvérisation ionique sous vide **résultant de la mise en oeuvre du procédé selon la revendication 1 et** comprenant une cible (1) et un support (2), **caractérisé en ce que** la cible (1) est fixée sur le support (2) par l'intermédiaire de plots espacés (3) d'une matière adhésive en combinaison avec une grille d'espacement (5) d'épaisseur déterminée inférieure à celle des plots.

**Claims**

1. Method for assembling at least two plates (1) and (2), **characterized in that**:

   - on one of the plates (2) are deposited studs (3) made of an adhesive material spaced apart from each other;
   - to the plate (2) receiving the studs (3) is fitted a grid (5) of pre-set thickness less than that of the studs (3);
   - to one at least of the plates a perpendicular and uniform pressure is applied, such that the studs (3) spread out and come into contact with the opposite faces of two plates (1) and (2);
   - the spacing (4) between the studs is determined so that after spreading out under the applied pressure, no air is trapped between said studs.

2. Method as claimed in claim 1, **characterized in that** the grid (5) defines openings of any geometric shapes with a surface area less than that of the studs.

3. Method as claimed in claim 1, **characterized in that** the percentage opening of the grid is between 20 and 50 %.

4. Method as claimed in claim 1, **characterized in that** the adhesive material is a bonding adhesive.

5. Method as claimed in claim 4, **characterized in that** the bonding adhesive is selected to polymerize in contact with the moist air at ambient temperature.

6. Method as claimed in claim 1, **characterized in that** the bonding adhesive is an acetoxy type silicone elastomer.

7. Use of the assembling method as claimed in any one of claims 1 to 6 to produce an ion sputtering target, one of the plates (1) constituting the target as such, while the other plate constitutes the carrier for said target.

8. Vacuum ion sputtering assembly that is the result of implementing the method as claimed in claim 1 and including a target (1) and a carrier (2), **characterized in that** the target (1) is secured to the carrier (2) by means of spaced apart studs (3) made of an adhesive material in combination with a spacing grid (5) of pre-set thickness less than that of the studs.

**Patentansprüche**

1. Verfahren zur Montage von mindestens zwei Platten (1 und 2), **dadurch gekennzeichnet, dass:**

   - auf eine der Platten (2) räumlich voneinander getrennte Klötze (3) aus einem haftenden Material gesetzt werden;
   - auf die die Klötze (3) aufnehmende Platte (2) ein Gitter (5) mit einer bestimmten Dicke, die geringer ist als diejenige der Klötze (3), gelegt wird;
   - auf mindestens eine der Platten senkrecht dazu ein gleichförmiger Druck ausgeübt wird, so dass die Klötze (3) sich ausbreiten und mit den sich gegenüberliegenden Seiten von zwei Platten (1 und 2) in Kontakt kommen; der Abstand (4) der Klötze zueinander so beschaffen ist, dass nach der Ausbreitung unter dem ausgeübten Druck keine Luft zwischen den Klötzen eingeschlossen ist.

2. Verfahren nach Anspruch 1, **dadurch gekennzeichnet, dass** das Gitter (5) Öffnungen in beliebigen geometrischen Formen besitzt, deren Fläche geringer ist als diejenige der Klötze.

3. Verfahren nach Anspruch 1, **dadurch gekennzeichnet, dass** der Öffnungsgrad des Gitters zwischen 20 und 50 % liegt.

4. Verfahren nach Anspruch 1, **dadurch gekennzeichnet, dass** das haftende Material ein Klebstoff ist.

5. Verfahren nach Anspruch 4, **dadurch gekennzeichnet, dass** der Klebstoff so gewählt wird, dass er im Kontakt der feuchten Luft mit der Umgebungstemperatur polymerisiert.

6. Verfahren nach Anspruch 1, **dadurch gekennzeichnet, dass** der Klebstoff ein Silikonelastomer vom Typ Acetoxy ist.

7. Verwendung des Verbindungsverfahrens nach einem der Ansprüche 1 - 6 zur Herstellung eines Sputterziels, wobei eine der Platten (1) das Ziel als solches bildet, während die andere Platte die Unterlage des besagten Ziels ist.

8. Aus der Umsetzung des Verfahrens nach Anspruch 1 resultierendes Vakuum-Sputter-System mit einem Ziel (1) und einer Unterlage (2), **dadurch gekennzeichnet, dass** das Ziel (1) durch voneinander getrennte Klötze (3) aus einem haftenden Material in Verbindung mit einem Abstandsgitter (5) in einer bestimmten Dicke, die geringer ist als diejenige der Klötze, auf der Unterlage (2) befestigt ist.

**Fig. 1**

**Fig. 2**  **Fig. 3**  **Fig. 4**  **Fig. 5**  **Fig. 6**

**Fig. 7**  **Fig. 8**

**Fig. 9**

**Fig. 10**

**Fig. 11**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060266643 A
- US 20060283703 A

- WO 2006132916 A